# EUROPEAN PATENT APPLICATION

(11) **EP 2 172 766 A1**
(43) Date of publication of application: **07.04.2010**
(21) Application number: 09169151.9
(22) Date of filing: 01.09.2009
(51) Int. Cl.: G01N 21/31, G01N 21/35, G01N 21/39, G03F 1/00, G03F 7/20, G01J 3/427

(54) **Lithographic apparatus and humidity measurement system**

(30) Priority: 03.10.2008 US 136789 P
(71) Applicant: ASML Netherlands B.V., 5504 DR Veldhoven (NL)
(72) Inventor: Van Dooren, Leon, Delft (NL); Jacobs, Johannes, 5616 BE, Eindhoven (NL); Jonker, Wouter, 3314 ZV, Dordrecht (NL)
(74) Representative: Raukema, Age

(57) **Abstract**

A humidity measurement system (10) for use in, for example, a lithographic apparatus. The humidity measurement system (10) includes a tunable laser diode (11) configured to emit a measurement radiation beam (5) having a wavelength in a wavelength range. The wavelength range includes a first wavelength associated with an absorption peak of water molecules. A signal processing unit (14) is connected to a radiation detector (12). The signal processing unit (14) is configured to measure an intensity of the measurement radiation beam (5) of the tunable laser diode (11) subjected to absorption. The signal processing unit (14) is also connected to the tunable laser diode (11) for obtaining wavelength information. The signal processing unit (14) is arranged to detect an extreme value in a measured intensity as function of the wavelength and to calculate a humidity value from the detected extreme value.

## Description

### FIELD

The present invention relates to a humidity measurement system, which may be used in a lithographic apparatus and a method for manufacturing a device.

### BACKGROUND

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. comprising part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.

Many measurement principles exist to measure humidity, which in some circumstances or applications is also used in a lithography apparatus. Most methods do not measure the humidity of the air directly, but rely on 2nd-order effects: for example changes in electrical properties or mechanical resonance frequency of a hygroscopic coated substrate, or a change in reflectivity of a chilled mirror. Direct methods include cavity ring humidity sensors, which use optical absorption to measure very low (<ppm) concentrations; and lyman-alpha sensors which utilize the absorption of lyman-alpha radiation generated by an electrical discharge of hydrogen. Cavity ring sensors are only suitable for very low (<ppm) concentrations. Lyman-alpha sensors are inaccurate and have a limited lifetime of source and optics due to contamination and degradation issues. All sensors that rely on 2nd-order effects require an equilibrium to form. Due to the limited speed of the physical processes involved, they are comparatively very slow and suffer from a measurement 'lag'.

### SUMMARY

It is desirable to obtain a humidity measurement system which may be used in specific circumstances in lithography applications, which have a sufficient accuracy and measurement rate.

According to an aspect of the invention, there is provided a humidity measurement system that includes a tunable laser diode configured to emit a measurement radiation beam having a wavelength in a wavelength range, the wavelength range comprising a first wavelength associated with an absorption peak of water molecules, and a signal processing unit connected to a radiation detector configured to measure an intensity of the measurement radiation beam of the tunable laser diode subjected to absorption, and connected to the tunable laser diode for obtaining wavelength information. The signal processing unit is arranged to detect an extreme value in a measured intensity as function of the wavelength and to calculate a humidity value from the detected extreme value.

According to an aspect of the invention, there is provided a humidity measurement method comprising providing a measurement radiation beam having a wavelength in a wavelength range, the wavelength range comprising a first wavelength associated with an absorption peak of water molecules, measuring an intensity of the measurement radiation beam subjected to absorption as function of wavelength, detecting an extreme value in the measured intensity in the wavelength range, and calculating a humidity value from the detected extreme value.

According to an aspect of the invention, there is provided a lithographic apparatus arranged to transfer a pattern from a patterning device onto a substrate, wherein the lithographic apparatus further comprises an interferometer position measurement system and a humidity measurement system according to the present invention connected to the interferometer position measurement system, the interferometer position measurement system being arranged to receive humidity data for correction purposes.

According to an aspect of the invention, there is provided a lithographic apparatus arranged to transfer a pattern from a patterning device onto a substrate, wherein the lithographic apparatus further comprises one or more immersion system components and a humidity measurement system according to the present invention to measure humidity in air extracted from the one or more immersion system components and to determine a thermal load on the one or more immersion system components.

According to an aspect of the invention, there is provided a lithographic apparatus that includes a support constructed and arranged to support a patterning device. The patterning device is configured to pattern a beam of radiation. A substrate support is constructed and arranged to support a substrate, and a projection system is constructed and arranged to project a patterned beam of radiation onto the substrate. The apparatus includes an interferometer constructed and arranged to measure a position of the substrate, and a humidity measurement system connected to the interferometer. The humidity measurement system includes a tunable laser diode configured to emit a measurement radiation beam having a wavelength in a wavelength range, the wavelength range comprising a first wavelength associated with an absorption peak of water molecules, and a signal processing unit connected to a radiation detector configured to measure an intensity of the measurement radiation beam of the tunable laser diode subjected to absorption, and connected to the tunable laser diode for obtaining wavelength information. The signal processing unit is arranged to detect an extreme value in a measured intensity as function of the wavelength and to calculate a humidity value from the detected extreme value. The interferometer is configured to receive humidity data from the humidity measurement system for correction purposes.

According to an aspect of the invention, there is provided a lithographic apparatus that includes a support constructed and arranged to support a patterning device. The patterning device is configured to pattern a beam of radiation. A substrate support is constructed and arranged to support a substrate, and a projection system is constructed and arranged to project a patterned beam of radiation onto the substrate. The apparatus includes an immersion system positioned between the projection system and the substrate support and/or the substrate, and a humidity measurement system constructed and arranged to measure humidity in air extracted from one or more components of the immersion system and to determine thermal load on the one or more immersion system components. The humidity measurement system includes a tunable laser diode configured to emit a measurement radiation beam having a wavelength in a wavelength range, the wavelength range comprising a first wavelength associated with an absorption peak of water molecules, and a signal processing unit connected to a radiation detector configured to measure an intensity of the measurement radiation beam of the tunable laser diode subjected to absorption, and connected to the tunable laser diode for obtaining wavelength information. The signal processing unit is arranged to detect an extreme value in a measured intensity as function of the wavelength and to calculate a humidity value from the detected extreme value.

### BRIEF DESCRIPTION OF THE DRAWINGS

Embodiments of the invention will now be described, by way of example only, with reference to the accompanying schematic drawings in which corresponding reference symbols indicate corresponding parts, and in which:

Figure 1 depicts a lithographic apparatus according to an embodiment of the invention;

Figure 2 depicts a schematic diagram of an embodiment of the humidity measurement system according to the present invention; and

Figure 3 depicts an exemplary graph of an intensity profile as function of wavelength.

### DETAILED DESCRIPTION

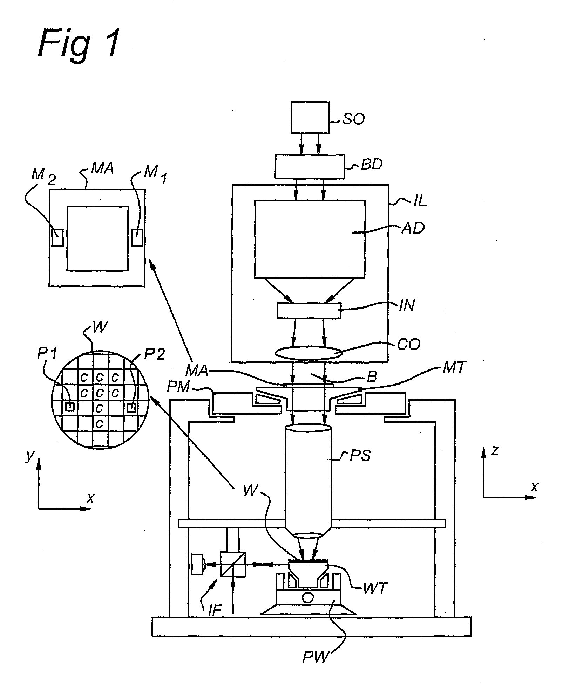

Figure 1 schematically depicts a lithographic apparatus according to one embodiment of the invention. The apparatus comprises an illumination system (illuminator) IL configured to condition a radiation beam B (e.g. UV radiation or DUV radiation); a support structure (e.g. a mask table) MT constructed to support a patterning device (e.g. a mask) MA and connected to a first positioner PM configured to accurately position the patterning device in accordance with certain parameters; a substrate support (e.g. a substrate or wafer table) WT constructed to hold a substrate (e.g. a resist-coated wafer) W and connected to a second positioner PW configured to accurately position the substrate in accordance with certain parameters; and a projection system (e.g. a refractive projection lens system) PS configured to project a pattern imparted to the radiation beam B by patterning device MA onto a target portion C (e.g. comprising one or more dies) of the substrate W.

The illumination system may include various types of optical components, such as refractive, reflective, magnetic, electromagnetic, electrostatic or other types of optical components, or any combination thereof, for directing, shaping, or controlling radiation.

The support structure supports, i.e. bears the weight of, the patterning device. It holds the patterning device in a manner that depends on the orientation of the patterning device, the design of the lithographic apparatus, and other conditions, such as for example whether or not the patterning device is held in a vacuum environment. The support structure can use mechanical, vacuum, electrostatic or other clamping techniques to hold the patterning device. The support structure may be a frame or a table, for example, which may be fixed or movable as required. The support structure may ensure that the patterning device is at a desired position, for example with respect to the projection system. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

The patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam which is reflected by the mirror matrix.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

As here depicted, the apparatus is of a transmissive type (e.g. employing a transmissive mask). Alternatively, the apparatus may be of a reflective type (e.g. employing a programmable mirror array of a type as referred to above, or employing a reflective mask).

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure.

The lithographic apparatus may also be of a type wherein at least a portion of the substrate may be covered by a liquid having a relatively high refractive index, e.g. water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems. The term "immersion" as used herein does not mean that a structure, such as a substrate, must be submerged in liquid, but rather only means that liquid is located between the projection system and the substrate during exposure.

Referring to Figure 1, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may comprise an adjuster AD for adjusting the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may comprise various other components, such as an integrator IN and a condenser CO. The illuminator may be used to condition the radiation beam, to have a desired uniformity and intensity distribution in its cross-section.

The radiation beam B is incident on the patterning device (e.g., mask MA), which is held on the support structure (e.g., mask table MT), and is patterned by the patterning device. Having traversed the mask MA, the radiation beam B passes through the projection system PS, which focuses the beam onto a target portion C of the substrate W. With the aid of the second positioner PW and position sensor IF (e.g. an interferometric device, linear encoder or capacitive sensor), the substrate table WT can be moved accurately, e.g. so as to position different target portions C in the path of the radiation beam B. Similarly, the first positioner PM and another position sensor (which is not explicitly depicted in Figure 1) can be used to accurately position the mask MA with respect to the path of the radiation beam B, e.g. after mechanical retrieval from a mask library, or during a scan. In general, movement of the mask table MT may be realized with the aid of a long-stroke module (coarse positioning) and a short-stroke module (fine positioning), which form part of the first positioner PM. Similarly, movement of the substrate table WT may be realized using a long-stroke module and a short-stroke module, which form part of the second positioner PW. In the case of a stepper (as opposed to a scanner) the mask table MT may be connected to a short-stroke actuator only, or may be fixed. Mask MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the mask MA, the mask alignment marks may be located between the dies.

The depicted apparatus could be used in at least one of the following modes:

1. In step mode, the mask table MT and the substrate table WT are kept essentially stationary, while an entire pattern imparted to the radiation beam is projected onto a target portion C at one time (i.e. a single static exposure). The substrate table WT is then shifted in the X and/or Y direction so that a different target portion C can be exposed. In step mode, the maximum size of the exposure field limits the size of the target portion C imaged in a single static exposure.

2. In scan mode, the mask table MT and the substrate table WT are scanned synchronously while a pattern imparted to the radiation beam is projected onto a target portion C (i.e. a single dynamic exposure). The velocity and direction of the substrate table WT relative to the mask table MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion.

3. In another mode, the mask table MT is kept essentially stationary holding a programmable patterning device, and the substrate table WT is moved or scanned while a pattern imparted to the radiation beam is projected onto a target portion C. In this mode, generally a pulsed radiation source is employed and the programmable patterning device is updated as required after each movement of the substrate table WT or in between successive radiation pulses during a scan. This mode of operation can be readily applied to maskless lithography that utilizes programmable patterning device, such as a programmable mirror array of a type as referred to above.

Combinations and/or variations on the above described modes of use or entirely different modes of use may also be employed.

In immersion lithography tools, a 2-phase flow of air and water is extracted through the wafer table during the exposure phase. Evaporation of water into the airflow may cause an unwanted heat load inside the wafer table. In order to quantify this heat load, among others the increase in the humidity of the air as it flows into, and out of the wafer table is determined. Commercially available humidity sensors do not meet the demanding specifications for measurement frequency (> 1 Hz) and accuracy (< 1%).

Methods which rely on the formation or disturbance of some sort of equilibrium of water vapor with its surroundings are generally too slow because of the limited speed by which a physical/chemical equilibrium can shift. Mass spectrometry meets the specifications for accuracy and measurement frequency, but this method is bulky and expensive.

In this description, terms are used which are considered known and clear to the person skilled in the art, but for clarity, in this description the following terms are used in the given interpretation. Humidity refers to the presence of water vapor in the air. Relative humidity is the ratio of the actual water vapor pressure and the saturation (maximum) water vapor pressure. It is typically expressed as a percentage. Because the maximum possible water vapor pressure varies with temperature, the relative humidity is temperature dependent. Absolute humidity is the quantitative amount of water vapor in a given sample. It is expressed in absolute units; for example a mass fraction (kg/kg) or molar fraction (mol/mol). Since the molar volume is identical for ideal gases, the molar fraction and volume fraction can be considered equal.

According to the present invention, the absorption of light by water molecules is used to directly measure the humidity in a space, e.g. a space in which the airflow of a lithography apparatus flows. It has been found that an absorption peak caused by water molecules is e.g. present at about 1877 nm. Examples of other peaks which may be usable are at about 2500, 1950, 1450 and 1392 nm.

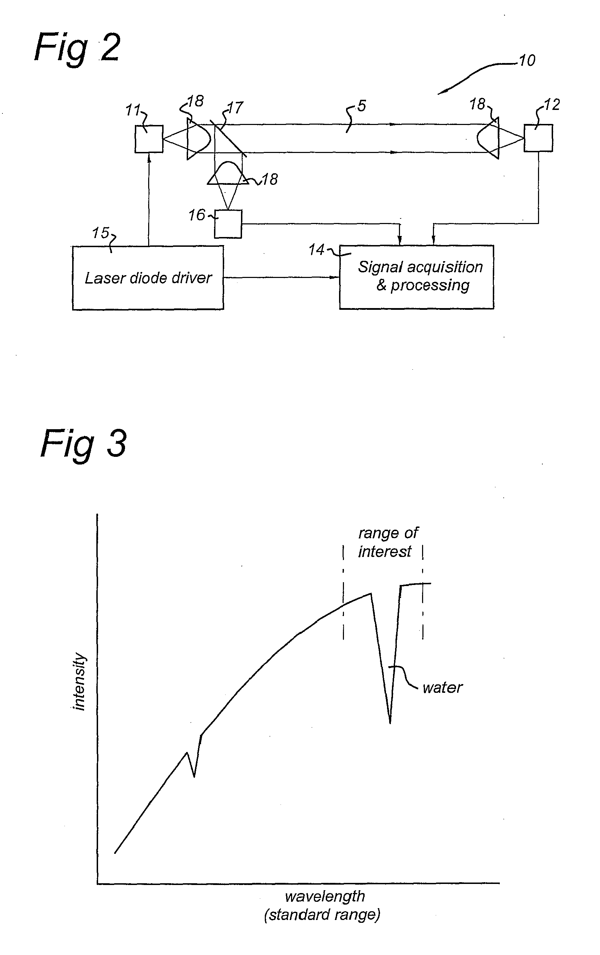

An exemplary embodiment of a humidity measurement system 10 is shown schematically in Figure 2. A radiation source 11, e.g. in the form of a laser diode, emits a beam of radiation which is transformed by a lens 18 into a measurement beam. The measurement beam 5 is directed towards a detector 12. Using a further lens 18 and the detector 12, a measured intensity signal (including absorption in the entire path of measurement beam 5) is fed to a signal acquisition and processing unit 14.

The laser diode 11 is connected to a laser diode driver 15, which controls the characteristics of the measurement beam 5, most importantly the wavelength and output power, e.g. using temperature and current control. The laser diode 11 may be a tunable laser diode, known as such in the art, of which the output wavelength may be accurately controlled. The laser diode driver 15 can be arranged to have the laser diode 11 emit a beam with a varying wavelength, e.g. a continuous sweep over a predetermined wavelength range. The laser diode driver 15 is connected to the signal acquisition and processing unit 14 to provide precise wavelength information (directly as a wavelength signal or indirectly, e.g. providing only parameters such as currents and temperatures used as set points for the tunable laser diode 11).

In an embodiment, the humidity measurement system 10 further comprises a beam splitter 17 which directs a part of the measurement beam to a reference detector 16 (via an additional lens 18). The intensity reference signal measured using the reference detector 16 is fed to the signal acquisition and processing unit 14. This reference signal can be used to compensate the processing of the measured intensity signal from detector 12 for drift and/or source instabilities.

The lenses 18 used in this measurement set-up may be aspheric lenses, which provide a well defined parallel measurement beam 5 having a given beam width and well defined measurement spots on the detector 12 and reference detector 16. The measurement beam width and length determine the actual volume associated with the humidity measurement. This allows to adapt the measurement beam width and length according to specific measurement needs. In an exemplary embodiment the beam width was in the order of a few millimeters.

In Figure 3, an exemplary intensity profile as measured is shown as function of wavelength. In the range of interest (e.g. 1877nm +/- 10%), an absorption peak caused by water molecules is present (but far from other absorption peaks, of which one is shown in Figure 3 at a lower wavelength). By controlling the tunable laser diode 11 to make a scan over a (continuous) wavelength range, the exact absorption peak extreme caused by water molecules at about 1877 nm can be determined very accurately. The signal acquisition and processing unit 14 can be arranged to very precisely determine the extreme intensity value in the range of interest, and using the reference signal as described above, it is possible to accurately determine the humidity in the path of measurement beam 5.

In an embodiment, the signal acquisition and processing unit 14 may be arranged to determine the reference signal from the intensity measurements outside the 1877 nm absorption peak, as for those wavelengths no absorption takes place. The reference value at 1877 nm can e.g. be calculated using an extrapolation of the intensity values measured further away from the 1877 nm wavelength.

In an embodiment, there is provided a humidity measurement system comprising a tunable laser diode for providing a measurement radiation beam having a wavelength in a wavelength range, the wavelength range comprising a first wavelength associated with an absorption peak of water molecules, a signal processing unit connected to a radiation detector for measuring an intensity of the measurement radiation beam of the tunable laser diode subjected to absorption, and connected to the tunable laser diode for obtaining wavelength information, wherein the signal processing unit is arranged to detect an extreme value in a measured intensity as function of the wavelength and to calculate a humidity value from the detected extreme value.

In an embodiment, the first wavelength is 1877 nm. The wavelength range is e.g. from 1877 nm +/- 1.5nm. This covers the entire absorption peak of water molecules and yet it is possible to use normally available and affordable components.

In an embodiment, a measured intensity at a second wavelength (outside the absorption peak caused by water molecules around the first wavelength) may be used to determine a reference value at the first wavelength (i.e. without absorption by water molecules), e.g. for compensating drift or source instabilities. From the measured intensity at the second wavelength (or a plurality of measured intensities at multiple wavelengths), an entire range as function of wavelength can also be determined to obtain a reference value at the first wavelength, as discussed in an embodiment above.

The humidity measurement system may further comprise a beam splitter receiving the measurement radiation beam from the tunable laser diode and directing a reference beam to a further radiation detector, the further radiation detector being connected to the signal processing unit for providing a reference intensity signal.

In an embodiment, the humidity measurement system further comprises one or more lenses for providing the measurement radiation beam, and possible also to focus the beam on respective detectors.

The signal processing unit is in an embodiment arranged to determine a humidity value based on a humidity model which receives the measured intensity value, and the temperature and pressure in the measurement radiation beam.

In accordance with an embodiment, there is provided a humidity measurement method comprising providing a measurement radiation beam having a wavelength in a wavelength range, the wavelength range comprising a first wavelength associated with an absorption peak of water molecules, measuring an intensity of the measurement radiation beam subjected to absorption as function of wavelength, detecting an extreme value in the measured intensity in the wavelength range, and calculating a humidity value from the detected extreme value. The first wavelength is e.g. 1877 nm, and the wavelength range may be from 1877 nm +/- 10%. A measured intensity at a second wavelength may be used to determine a reference value at the first wavelength, e.g. for compensating drift or source instabilities. The method may further comprise determining a humidity value based on a humidity model which receives the measured intensity value, and the temperature and pressure in the measurement radiation beam.

As the present embodiments of the humidity measurement system 10 measure directly and instantly the absorption of light at 1877 nm by water molecules in the measurement space 5, a high measurement rate is possible (>1 Hz). Furthermore, the elements of the humidity measurement system are not prone to degradation, and can be used over the entire humidity range of 0...100%, regardless of pressure or temperature in the measurement space 5. The changes in absorption can be measured very accurately, which in combination with a model taking into account how other factors (temperature, pressure) affect absorption, results in a high measurement accuracy. Tunable laser diodes 11 operating in a wavelength range around 1877 nm are readily and affordably available.

In lithography applications, e.g. in the lithography apparatus as described with reference to Figure 1, the present humidity measurement system 10 may be used for a variety of subsystems. In an embodiment, the humidity measurement system 10 may be applied to correct the influence of humidity changes on the wafer stage WS interferometer position measurement system. The high measurement frequency and accuracy will allow real time correction. A further application may be considered for immersion based lithography systems. Some components in the lithography apparatus, especially those located in the wafer table or in the immersion hood are thermally loaded, and the humidity of the air that is extracted from these components is a direct measure for that thermal load. This direct measurement of thermal load on various components in an immersion system using the present humidity measurement system 10 allows to optimize the design of the wafer table and the immersion hood.

Embodiments of the present invention relate to a lithographic apparatus arranged to transfer a pattern from a patterning device onto a substrate, wherein the lithographic apparatus further comprises an interferometer position measurement system and a humidity measurement system according to any one of the embodiments described above connected to the interferometer position measurement system, the interferometer position measurement system being arranged to receive humidity data for correction purposes.

Embodiments of the present invention relate to a lithographic apparatus arranged to transfer a pattern from a patterning device onto a substrate, wherein the lithographic apparatus further comprises one or more immersion system components and a humidity measurement system according to any one of the embodiments described above to measure humidity in air extracted from the one or more immersion system components and to determine thermal load on the one or more immersion system components.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat-panel displays, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist), a metrology tool and/or an inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g. having a wavelength of or about 365, 355, 248, 193, 157 or 126 nm) and extreme ultra-violet (EUV) radiation (e.g. having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

While specific embodiments of the invention have been described above, it will be appreciated that the invention may be practiced otherwise than as described. For example, the invention may take the form of a computer program containing one or more sequences of machine-readable instructions describing a method as disclosed above, or a data storage medium (e.g. semiconductor memory, magnetic or optical disk) having such a computer program stored therein.

The descriptions above are intended to be illustrative, not limiting. Thus, it will be apparent to one skilled in the art that modifications may be made to the invention as described without departing from the scope of the claims set out below.

## Claims

1. A humidity measurement system comprising:
a tunable laser diode configured to emit a measurement radiation beam having a wavelength in a wavelength range, the wavelength range comprising a first wavelength associated with an absorption peak of water molecules; and
a signal processing unit connected to a radiation detector configured to measure an intensity of the measurement radiation beam of the tunable laser diode subjected to absorption, and connected to the tunable laser diode for obtaining wavelength information,
wherein the signal processing unit is arranged to detect an extreme value in a measured intensity as function of the wavelength and to calculate a humidity value from the detected extreme value.

2. The humidity measurement system according to claim 1, wherein the first wavelength is 1877 nm.

3. The humidity measurement system according to claim 2, wherein the wavelength range is from 1877 nm +/- 1.5nm.

4. The humidity measurement system according to anyone of claims 1-3, wherein a measured intensity at a second wavelength is used to determine a reference value at the first wavelength.

5. The humidity measurement system according to anyone of claims 1-4, further comprising a beam splitter configured to receive the measurement radiation beam from the tunable laser diode and direct a reference beam to a further radiation detector, the further radiation detector being connected to the signal processing unit and configured to provide a reference intensity signal.

6. The humidity measurement system according to anyone of claims 1-5, wherein the signal processing unit is further arranged to determine a humidity value based on a humidity model which receives the measured intensity value, and the temperature and pressure in the measurement radiation beam.

7. A humidity measurement method comprising:
providing a measurement radiation beam having a wavelength in a wavelength range, the wavelength range comprising a first wavelength associated with an absorption peak of water molecules;
measuring an intensity of the measurement radiation beam subjected to absorption as a function of wavelength;
detecting an extreme value in the measured intensity in the wavelength range; and
calculating a humidity value from the detected extreme value.

8. The humidity measurement method according to claim 7, wherein the first wavelength is 1877 nm.

9. The humidity measurement method according to claim 8, wherein the wavelength range is from 1877 nm +/- 10%.

10. The humidity measurement method according to anyone of claims 7-9, wherein a measured intensity at a second wavelength is used to determine a reference value at the first wavelength.

11. The humidity measurement method according to anyone of claims 7-10, further comprising determining a humidity value based on a humidity model which receives the measured intensity value, and the temperature and pressure in the measurement radiation beam.

12. A lithographic apparatus arranged to transfer a pattern from a patterning device onto a substrate, the lithographic apparatus comprising an interferometric position measurement system and a humidity measurement system according to anyone of claims 1-6 connected to the interferometric position measurement system, the interferometric position measurement system being arranged to receive humidity data for correction purposes.

13. A lithographic apparatus arranged to transfer a pattern from a patterning device onto a substrate, the lithographic apparatus comprising one or more immersion system components and a humidity measurement system according to anyone of claims 1-6 to measure humidity in air extracted from the one or more immersion system components and to determine thermal load on the one or more immersion system components.

14. A lithographic apparatus comprising:
a support constructed and arranged to support a patterning device, the patterning device being configured to pattern a beam of radiation;
a substrate support constructed and arranged to support a substrate;
a projection system constructed and arranged to project a patterned beam of radiation onto the substrate;
an interferometric position measurement system constructed and arranged to measure a position of the substrate; and
a humidity measurement system connected to the interferometric position measurement system, the humidity measurement system comprising
a tunable laser diode configured to emit a measurement radiation beam having a wavelength in a wavelength range, the wavelength range comprising a first wavelength associated with an absorption peak of water molecules; and
a signal processing unit connected to a radiation detector configured to measure an intensity of the measurement radiation beam of the tunable laser diode subjected to absorption, and connected to the tunable laser diode for obtaining wavelength information, wherein the signal processing unit is arranged to detect an extreme value in a measured intensity as function of the wavelength and to calculate a humidity value from the detected extreme value,
wherein the interferometric position measurement system is configured to receive humidity data from the humidity measurement system for correction purposes.

15. A lithographic apparatus comprising:
a support constructed and arranged to support a patterning device, the patterning device being configured to pattern a beam of radiation;
a substrate support constructed and arranged to support a substrate;
a projection system constructed and arranged to project a patterned beam of radiation onto the substrate;
an immersion system positioned between the projection system and the substrate support and/or the substrate; and
a humidity measurement system constructed and arranged to measure humidity in air extracted from one or more components of the immersion system and to determine thermal load on the one or more immersion system components, the humidity measurement system comprising
a tunable laser diode configured to emit a measurement radiation beam having a wavelength in a wavelength range, the wavelength range comprising a first wavelength associated with an absorption peak of water molecules; and
a signal processing unit connected to a radiation detector configured to measure an intensity of the measurement radiation beam of the tunable laser diode subjected to absorption, and connected to the tunable laser diode for obtaining wavelength information, wherein the signal processing unit is arranged to detect an extreme value in a measured intensity as function of the wavelength and to calculate a humidity value from the detected extreme value.
